# EUROPEAN PATENT APPLICATION

(11) **EP 3 462 501 A1**
(43) Date of publication of application: **03.04.2019**
(21) Application number: 18197840.4
(22) Date of filing: 01.10.2018
(51) Int. Cl.: H01L 31/0224, H01L 31/048, H01L 31/05, H01L 31/072, H01L 31/0747

(54) **SOLAR CELL PANEL AND METHOD FOR MANUFACTURING THE SAME**

(30) Priority: 02.10.2017 KR 20170128496
(71) Applicant: LG Electronics Inc., Yeongdeungpo-Gu SEOUL 07336 (KR)
(72) Inventor: LEE, Jinhyung, 08592 Seoul (KR); PARK, Sangwook, 08592 Seoul (KR); BAK, Ayoung, 08592 Seoul (KR); YU, Jemin, 08592 Seoul (KR)
(74) Representative: Katérle, Axel

(57) **Abstract**

Disclosed is a solar cell panel including a solar cell; a sealing member surrounding and sealing the solar cell; a moisture barrier layer positioned between the solar cell and the sealing member and including silicon, a first cover member positioned at a surface of the solar cell on the sealing member; and a second cover member positioned at another surface of the solar cell on the sealing member.

## Description

### CROSS-REFERENCE TO RELATED APPLICATION

This application claims priority to and the benefit of Korean Patent Application No. 10-2017-0128496, filed in the Korean Intellectual Property Office on October 2, 2017, the entire contents of which are incorporated herein by reference.

### BACKGROUND OF THE INVENTION

### Field of the Invention

Embodiments of the invention relate to a solar cell panel and a method for manufacturing the same, and, more particularly, to a solar cell panel having an improved structure and a method for manufacturing the same.

### Description of the Related Art

Recently, as existing energy resources such as petroleum and coal are expected to be depleted, interest in alternative energy to replace them is increasing. Among them, solar cells are attracting attention as a next-generation battery that converts solar energy into electric energy. A solar cell can be manufactured through forming various layers and electrodes by design.

Since a solar cell is exposed to an external environment for a long time, it is manufactured in a form of a solar cell panel by a packaging process for protecting a solar cell. A solar cell panel requires long-term reliability because the solar cell panel generates electric energy for a long time in various environments. In a high-temperature and high-humidity environment, properties of the solar cell panel can be undesirably changed and output of the solar cell panel can be reduced.

### SUMMARY OF THE INVENTION

Therefore, embodiments of the invention have been made in view of the above problems, and the invention is to provide a solar cell panel being able to improve long-term reliability and to be manufactured by a simple process and a method for manufacturing the same.

A solar cell panel according to an embodiment of the invention includes a solar cell; a sealing member surrounding and sealing the solar cell; a moisture barrier layer including silicon and positioned between the solar cell and the sealing member, a first cover member positioned at a surface of the solar cell on the sealing member; and a second cover member positioned at another surface of the solar cell on the sealing member.

A method for manufacturing a solar cell panel according to an embodiment of the invention includes: forming a moisture barrier layer on a solar cell including a photoelectric conversion portion and an electrode; and laminating and attaching the solar cell having the moisture barrier layer, a sealing member for sealing the solar cell, a first cover member positioned at a surface of the solar cell on the sealing member, and a second cover member positioned at another surface of the solar cell on the sealing member.

According to an embodiment, a moisture barrier layer including silicon is positioned between a solar cell and a sealing member, and thus, corrosion of an electrode due to moisture permeation can be effectively prevented. This effect can be improved more when the electrode includes a transparent electrode layer and a conductive region includes amorphous silicon. As a result, output drop or power degradation that can occur in a high-temperature and high-humidity environment can be prevented or minimized, thereby improving long-term reliability of a solar cell panel.

In addition, the corrosion of the electrode due to the moisture penetration and thus the output drop or the power degradation can be prevented or reduced by a simple process.

### BRIEF DESCRIPTION OF THE DRAWINGS

FIG. 1 is an exploded perspective view showing a solar cell panel according to an embodiment of the invention.
FIG. 2 is a cross-sectional view taken along line II-II of FIG. 1.
FIG. 3 is a perspective view schematically showing first and second solar cells connected by an interconnector, which are included in the solar cell panel shown in FIG. 1.
FIG. 4 is an enlarged partial cross-sectional view of a part of the solar cell panel shown in FIG. 1
FIG. 5 is a front plan view of the solar cell included in FIG. 1.
FIGS. 6A to 6C are cross-sectional views showing a method for manufacturing a solar cell panel according to an embodiment of the invention.
FIG. 7 is a schematic partial cross-sectional view of a solar cell panel according to another embodiment of the invention.
FIG. 8 is a schematic partial cross-sectional view of a solar cell panel according to yet another embodiment of the invention.
FIG. 9 shows output drops of solar cell panels according to Embodiment 1 and Comparative Example 1 according to a test time when damp heat tests were conducted for 2000 hours.

### DETAILED DESCRIPTION OF THE EMBODIMENTS

Reference will now be made in detail to various embodiments of the invention, examples of which are illustrated in the accompanying drawings. The invention can, however, be embodied in many alternate forms and should not be construed as limited to the embodiments set forth herein.

In the drawings, illustration of parts unrelated to embodiments of the invention is omitted for clarity and simplicity of description. The same reference numerals designate the same or similar elements throughout the specification. In the drawings, thicknesses, widths or the like of elements are exaggerated or reduced for clarity of description, and should not be construed as limited to those illustrated in the drawings.

It will be understood that the terms "comprise" and/or "comprising," or "include" and/or "including" used in the specification specify the presence of stated elements, but do not preclude the presence or addition of one or more other elements. In addition, it will be understood that, when an element such as a layer, film, region, or plate is referred to as being "on" another element, it can be directly disposed on another element or can be disposed such that an intervening element is also present therebetween. Accordingly, when an element such as a layer, film, region, or plate is disposed "directly on" another element, this means that there is no intervening element between the elements.

Hereinafter, a solar cell panel and a method of manufacturing the same according to an embodiment of the invention will be described in detail with reference to the accompanying drawings.

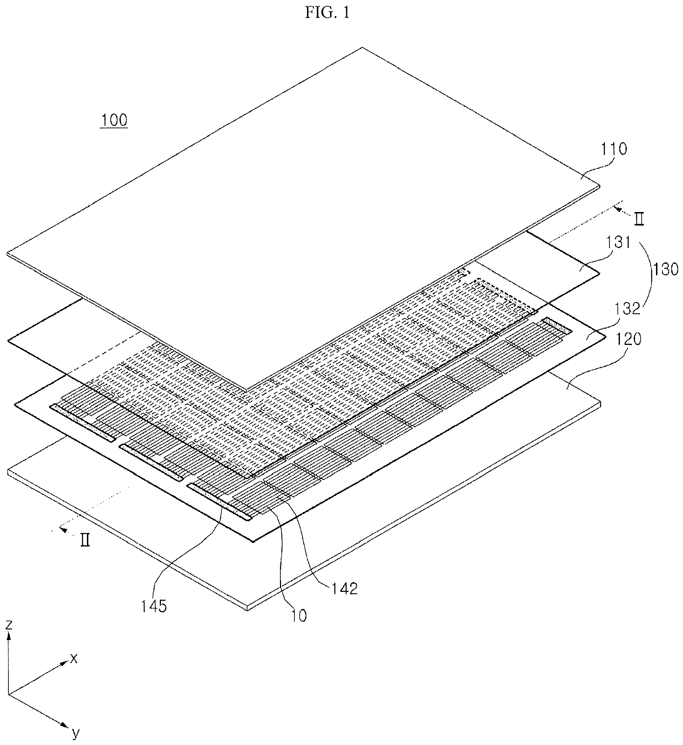

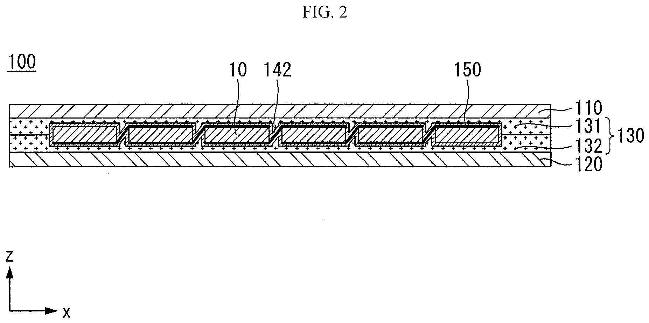

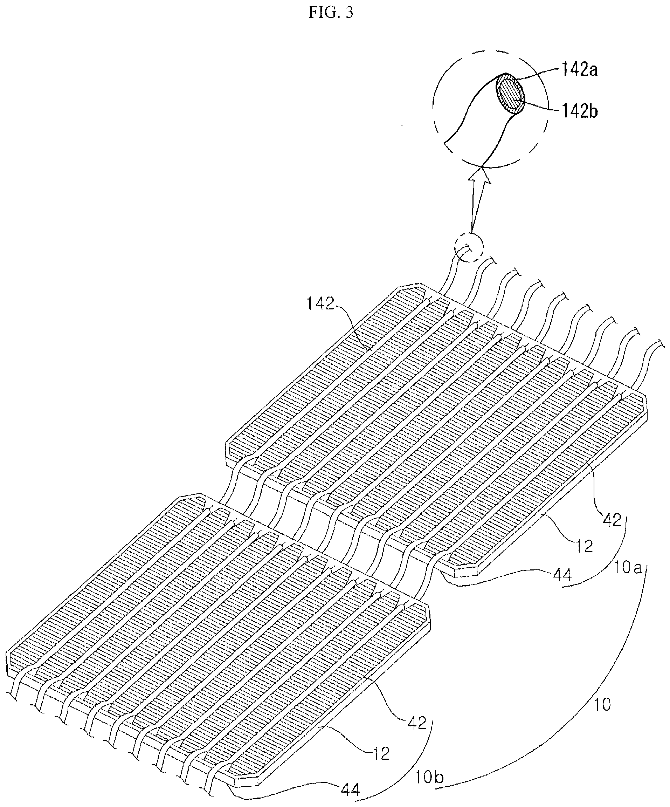

FIG. 1 is an exploded perspective view showing a solar cell panel according to an embodiment of the invention, and FIG. 2 is a cross-sectional view taken along line II-II of FIG. 1. FIG. 3 is a perspective view schematically showing first and second solar cells connected by an interconnector, which are included in the solar cell panel shown in FIG. 1. For simplicity, a moisture barrier layer is not shown in FIG. 1.

Referring to FIGS. 1 to 3, a solar cell panel 100 according to the embodiment includes a solar cell 10, a sealing member 130 that surrounds and seals the solar cell 10, a moisture barrier layer (a moisture-permeation prevention layer or a moisture-proof layer) 150 including silicon (Si) and positioned between the solar cell 10 and the sealing member 130, a first cover member (a front member) 110 positioned at a surface (for example, a front surface) of the solar cell 10 on the sealing member 13, and a second cover member (a back member) 120 positioned at the other surface (for example, a back surface) of the solar cell 10 on the sealing member 130.

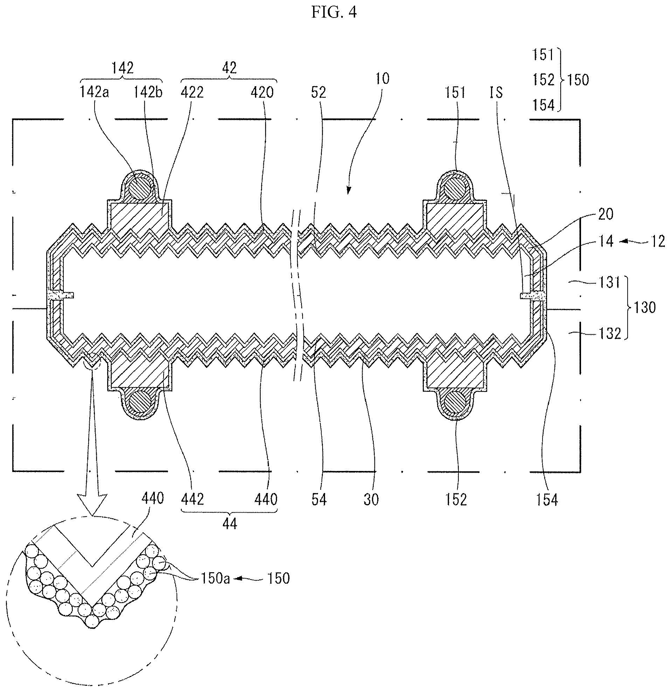

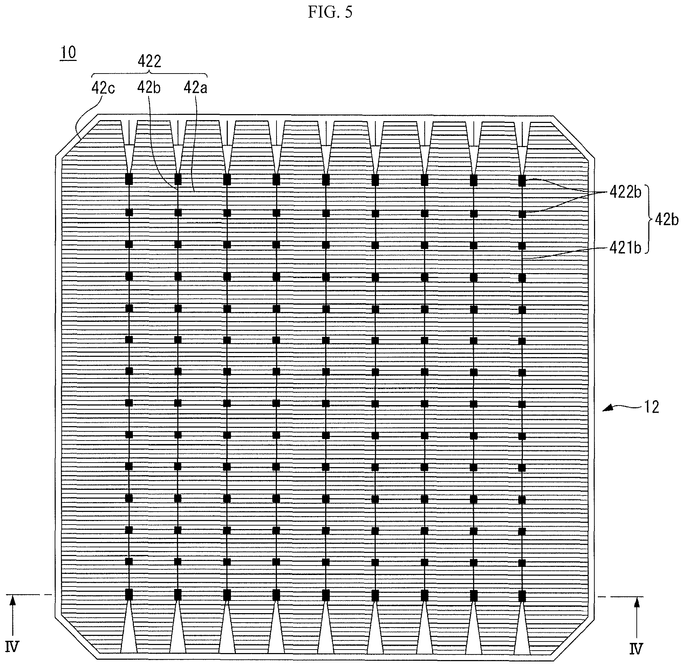

In this instance, the solar cell 10 includes a photoelectric conversion portion that generates electrons and holes by incident light, and an electrode 42 and 44 being electrically connected to the photoelectric conversion portion to collect electrons and holes generated by the photoelectric conversion portion. The photoelectric conversion portion and the electrode 42 and 44 can have any of various structures. An example of the solar cell 10 that can be applied to the solar cell panel 100 according to the embodiment of the invention will be described later in detail with reference to FIG. 4 and FIG. 5.

In the embodiment, a plurality of solar cells 10 can be electrically connected in series, parallel, or series-parallel by an interconnector (a wiring material) 142 and/or a bus ribbon 145. Various structures and shapes for connecting the solar cell 10 such as a ribbon and a wire can be applied to the interconnector 142 and/or the bus ribbon 145. For example, the interconnector 142 can connect a first electrode 42 positioned on a front surface of a first solar cell 10a and a second electrode 44 positioned on a back surface of a second solar cell 10b adjacent to the first solar cell 10a. However, embodiments of the invention are not limited thereto, and solar cells 10 adjacent to each other can be connected by other structures, shapes, or types.

In the embodiment, for example, a number of the interconnectors 142 is 6 or more (more specifically, 6 to 33, for example, 10 or more) at one surface of the solar cell 10. In one example, the interconnector 142 can have a width or a diameter of less than 1 mm (e.g., 250 um to 500 um). According to this, since the interconnectors 142 having a small width are provided in a large number, a movement distance of carriers can be minimized, and output of the solar cell panel 100 can be improved. In this instance, the interconnector 142 can be formed of a wire shape having a cross-section of a circular or rounded shape, and thus, light reflected by the interconnector 142 is total-reflected by the first cover member 110 or the like and is incident on the solar cell 10 again. Thus, efficiency of the solar cell 10 can be improved.

In this instance, the interconnector 142 and/or the bus ribbon 145 can be electrically and physically connected to the solar cell 10 or the interconnector 142 through a tabbing process using a solder material. Alternatively, the interconnector 142 and/or the bus ribbon 145 can be a conductive film formed of a conductive adhesive material. However, embodiments of the invention are not limited thereto. For example, the solar cell panel 100 can include only one solar cell 10, or a plurality of solar cells 10 can be electrically connected to each other by a connecting member other than the interconnector 142 and the bus ribbon 145.

In one example, the interconnector 142 having a wire shape can include a core layer 142a formed of a metal, and a solder layer 142b coated on a surface of the core layer 142a with a thin thickness. The solder layer 142b includes a solder material so that the interconnector 142 can be attached to or on the electrode 42 and 44 by soldering. For example, the core layer 142a can include Ni, Cu, Ag, Al, or so on as a base material. The solder layer 142b can include a material such as Pb, Sn, SnIn, SnBi, SnPb, SnPbAg, SnCuAg, SnCu, or so on as a base material. In this specification, the term of the base material means a material having the most weight percentage (wt%) in each layer. When the interconnection 142 has the core layer 142a and the solder layer 142b as described above, a plurality of interconnectors 142 can be bonded or attached to the solar cell 10 by a simple process of a tabbing process where heat and pressure are applied in a state that the plurality of interconnectors 142 are positioned on the solar cell 10 (for example, at the same time).

In the embodiment, a moisture barrier layer 150 can be formed on the solar cell 10 and/or the interconnector 142. A structure of the solar cell 10 will be described later in detail and then the moisture barrier layer 150 will be described in more detail.

The first cover member 110 is disposed on the first sealing member 131 to constitute a front surface of the solar cell panel 100 and the second cover member 120 is disposed on the second sealing member 132 to constitute a back surface of the solar cell panel 100. The first cover member 110 and the second cover member 120 can be formed of an insulating material capable of protecting the solar cell 10 from external shock, moisture, ultraviolet rays, or the like.

For example, the first cover member 110 can be a glass substrate having excellent durability, insulation property, moisture resistance, light transmittance, and the like. The second cover member 120 can be formed of a film or a sheet. For example, the second cover member 120 can include a plurality of layers each including a resin to improve various properties. In one example, the second cover member 120 can include a base member and a resin layer formed on at least one surface of the base member. The resin layer can include at least one of a first resin layer on a surface of the base member adjacent to the sealing member 130 and a second resin layer on the other surface of the base member opposite to the first resin layer.

The sealing member 130 includes a first sealing member 131 positioned on front surfaces of the solar cells 10 electrically connected to each other and a second sealing member 132 positioned on back surfaces of the solar cells 10 electrically connected to each other.

The sealing member 130 prevents moisture and oxygen from flowing into the solar cell 10 and chemically combines elements of the solar cell panel 100. The sealing member 130 can include an insulating material having a translucent or transparent property (a light-transmitting property) and an adhesive property as a base material. For example, the sealing member 130 can include an ethylene vinyl acetate resin (EVA), a polyvinyl butyral, a silicone resin, an ester resin, an olefin resin, a polyethylene resin, an ionomer, or so on.

However, embodiments of the invention are not limited thereto. Accordingly, the first and second sealing members 131 and 132, the first cover member 110, or the second cover member 120 can include any of various materials other than those described above, and can have any of various shapes other than those described above. For example, the first cover member 110 or the second cover member 120 can have any of various forms (e.g., a substrate, a film, a sheet, etc.) or any of various materials, or the second cover member 120 can include a non-translucent or non-transparent material or a reflective material.

The second cover member 120, the second sealing member 132, the solar cells 10 connected by the interconnectors 142, the first sealing member 131, and the first cover member 110 can be integrated by a staking and laminating process to form a solar cell panel 100. In this instance, in the embodiment, the moisture barrier layer 150 is positioned between the solar cell 10 and the sealing member 130. Hereinafter, the solar cell 10 will be described in detail with reference to FIGS. 4 and 5, and then, the moisture barrier layer 150 will be described in detail with reference to FIGS. 2 and 4.

FIG. 4 is an enlarged partial cross-sectional view of a part of the solar cell panel 100 shown in FIG. 1, and FIG. 5 is a front plan view of the solar cell 10 included in FIG. 1. For reference, FIG. 4 is a partial cross-sectional view taken along line IV-IV of FIG. 5. For clarity and simplicity, with respect to the first electrode 42, a first metal electrode layer 422 is mainly shown in FIG. 5.

Referring to FIGS. 4 and 5, a solar cell 10 according to the embodiment includes a semiconductor substrate 12 including a base region 14, a passivation layer 52 and 54 disposed on the semiconductor substrate 12, a conductive region 20 and 30 positioned on the passivation layer 52 and 54, and an electrode 42 and 44 electrically connected to the conductive region 20 and 30. The electrode 42 and 44 can include a transparent electrode layer 420 and 440 and a metal electrode layer 422 and 442 having a pattern and positioned on the transparent electrode layer 420 and 440.

The passivation layer 52 and 54 can include a first passivation layer 52 formed on one surface (for example, a front surface) of the semiconductor substrate 12 and a second passivation layer 52 formed on the other surface (for example, a back surface) of the semiconductor substrate 12. The conductive region 20 and 30 can include a first conductive region 20 formed on the first passivation layer 52 at the one surface of the semiconductor substrate 12 and a second conductive region 30 formed on the second passivation layer 54 at the other surface of the semiconductor substrate 12. The electrode 42 and 44 can include a first electrode 42 electrically connected to the first conductive region 20 and a second electrode 44 electrically connected to the second conductive region 30.

The semiconductor substrate 12 can include a base region 14 including a first or second conductivity type dopant at a relatively low doping concentration to have a first or second conductivity type. The base region 14 can be formed of a single material of a crystalline semiconductor (e.g., a single material of a single-crystalline or polycrystalline semiconductor, such as a single-crystalline or polycrystalline silicon, particularly a single-crystalline silicon) including a first or second conductivity type dopant. The solar cell 10 based on the base region 14 or the semiconductor substrate 12 having a high degree of crystallinity and having few defects is excellent in electrical properties. In the embodiment, the semiconductor substrate 12 can be formed of only the base region 14 which does not have a doped region formed by additional doping or the like. Thus, degradation of a passivation property of the semiconductor substrate 12 due to the doped region can be prevented.

At the front surface and/or the back surface of the semiconductor substrate 12, an anti-reflection structure (for example, a texturing structure having a concavo-convex shape, a protrusion-indentation shape, an unevenness shape, or irregularity, such as a pyramid shape) can be formed to minimize reflection. However, the texturing structure may not be formed at the front and back surfaces of the semiconductor substrate 12.

The first passivation layer 52 can be formed on the front surface of the semiconductor substrate 12 and the second passivation layer 54 can be formed on the back surface of the semiconductor substrate 12. As a result, the passivation property can be improved. In this instance, the first and second passivation layers 52 and 54 can be formed entirely on the front surface and the back surface of the semiconductor substrate 12, respectively. Accordingly, the first and second passivation layers 52 and 54 can be easily formed without additional patterning while having an excellent passivation property. Carriers pass through the first or second passivation layers 52 or 54 and are transferred to the first or second conductive region 20 or 30, and thus, thicknesses of the first and second passivation layers 52 and 54 can be less than thicknesses of the first conductive region 20 and the second conductive region 30, respectively.

In one example, the first and second passivation layers 52 and 54 can be formed of an intrinsic amorphous semiconductor (for example, an intrinsic amorphous silicon (i-a-Si)) layer. Then, the first and second passivation layers 52 and 54 can include the same semiconductor material as the semiconductor substrate 12 and have similar properties as the semiconductor substrate 12, and thus, passivation properties can be improved more effectively. As a result, the passivation properties can be greatly improved. However, embodiments of the invention are not limited thereto. Thus, the first and/or second passivation layers 52 and/or 54 can include an intrinsic amorphous silicon carbide (i-a-SiCx) layer or an intrinsic amorphous silicon oxide (i-a-SiOx) layer. According to this, effect due to a wide energy band gap can be improved, while passivation properties can be lower than in the instance of including the intrinsic amorphous silicon (i-a-Si) layer.

The first conductive region 20 including a first conductivity type dopant or having a first conductivity type with a higher doping concentration than the semiconductor substrate 12 is positioned on (e.g., is in contact with) the first passivation layer 52. The second conductive region 30 including a second conductivity type dopant or having a second conductivity type opposite to the first conductive type with a higher doping concentration than the semiconductor substrate 12 is positioned on (e.g., is in contact with) the second passivation layer 54. When the first and second passivation layers 52 and 54 contact the first and second conductive regions 20 and 30, respectively, a carrier movement path can be shortened and a structure can be simplified.

Since the first conductive region 20 and the second conductive region 30 are formed separately from the semiconductor substrate 12, the first conductive region 20 and the second conductive region 30 can have a material and/or a crystal structure different from that of the semiconductor substrate 12 to be easily formed on the semiconductor substrate 12.

For example, each of the first conductive region 20 and the second conductive region 30 can be formed by doping an amorphous semiconductor or so on, which can be easily manufactured by any of various methods such as a deposition method, with a first or second conductivity type dopant. Then, the first conductive region 20 and the second conductive region 30 can be easily formed by a simple process.

In one example, the semiconductor substrate 12 can have a first conductivity type. The first conductive region 20 has the same conductivity type as that of the semiconductor substrate 12 and has a high doping concentration than the semiconductor substrate 12 to form a front surface field region, and the second conductive region 30 has a conductivity type opposite to that of the semiconductor substrate 12 to form an emitter region. Then, the second conductive region 30, which is an emitter region, is positioned on the back surface of the semiconductor substrate 12 and does not interfere with light absorption to the front surface, and thus, the second conductive region 20 can have a relatively large thickness. The first conductive region 20, which is a front surface field region and is not directly involved in photoelectric conversion, is positioned on the front surface of the semiconductor substrate 12. The first conductive region 20 is related to light absorption at the front surface and thus the first conductive region 20 can have a relatively small thickness. Thus, the light loss due to the first conductive region 20 can be minimized. However, embodiments of the invention are not limited thereto. The semiconductor substrate 12 can have a second conductivity type, the first conductive region 20 can be an emitter region, the second conductive region 30 can be a back surface field region.

A p-type dopant used as the first or second conductivity type dopant can include a Group 3 element such as boron (B), aluminum (Al), gallium (Ga), indium (In), or so on. An n-type dopant used as the first or second conductivity type dopant can include a Group 5 element such as phosphorus (P), arsenic (As), bismuth (Bi), antimony (Sb), or so on. In addition, any of various dopants can be used as the first or second conductivity type dopant.

In one example, the semiconductor substrate 12 and the first conductive region 20 can have an n-type, and the second conductive region 30 can have a p-type. According to this, the semiconductor substrate 12 has an n-type, and a lifetime of carriers can be excellent. For example, the semiconductor substrate 12 and the first conductive region 20 can include phosphorus (P) as an n-type dopant and the second conductive region 30 can include boron (B) as a p-type dopant. However, embodiments of the invention are not limited thereto, and the first conductivity type can be p-type and the second conductivity type can be n-type.

In the embodiment, the first conductive region 20 and the second conductive region 30 each includes at least one of an amorphous silicon (a-Si) layer, an amorphous silicon oxide (a-SiOx) layer, an amorphous silicon carbide (a-SiCx) layer, an indium-gallium-zinc oxide (IGZO) layer, a titanium oxide (TiOx) layer, and a molybdenum oxide (MoOx) layer. In this instance, the amorphous silicon (a-Si) layer, the amorphous silicon oxide (a-SiOx) layer, or the amorphous silicon carbide (a-SiCx) layer can be doped with the first or second conductivity type dopant. The indium-gallium-zinc oxide layer, the titanium oxide layer, or the molybdenum oxide layer can selectively collect electrons or holes by itself without a dopant to perform the same function as an n-type or p-type conductive region. In one example, the first and second conductive regions 20 and 30 can each include an amorphous silicon layer. Then, the first and second conductive regions 20 and 30 can include the same semiconductor material (i.e., silicon) as the semiconductor substrate 12 and can have similar properties to the semiconductor substrate 12. Thus, carriers can move more effectively and a stable structure can be realized.

The first electrode 42 electrically connected to the first conductive region 20 is formed on (e.g., is in contact with) the first conductive region 20 and the second electrode 44 electrically connected to the second conductive region 30 is formed on (e.g., is in contact with) the second conductive region 30.

The first electrode 42 can include a first transparent electrode layer 420 disposed on the first conductive region 20 and a first metal electrode layer 422 disposed on the first transparent electrode layer 420. The interconnector 142 or the solder layer 142b is attached to the first metal electrode layer 422.

In this instance, the first transparent electrode layer 420 can be entirely formed on (e.g., in contact with) the first conductive region 20. The wording of "entirely formed" can include not only an instance of covering an entire portion without an empty portion, but also instance of inevitably not covering a portion. When the first transparent electrode layer 420 is entirely formed on the first conductive region 20 as described above, carriers can easily reach the first metal electrode layer 422 through the first transparent electrode layer 420, and resistance in a lateral direction can be reduced. Since crystallinity of the first conductive region 20 formed of an amorphous semiconductor layer or the like is relatively low and a mobility of carriers can be low, the first transparent electrode layer 420 is included to reduce resistance when carrier move in a lateral direction.

Since the first transparent electrode layer 420 is entirely formed on the first conductive region 20 as described above, the first transparent electrode layer 420 can be formed of a material capable of transmitting light (a light-transmitting material or a transparent material). For example, the first transparent electrode layer 420 can include at least one of an indium tin oxide (ITO), an aluminum zinc oxide (AZO), a boron zinc oxide (BZO), an indium tungsten oxide (IWO), and an indium cesium oxide (ICO). However, embodiments of the invention are not limited thereto and thus the first transparent electrode layer 420 can include any of various other materials.

In this instance, in the embodiment, the first transparent electrode layer 420 can include hydrogen while using the above-described material as a main material or a base material. When the first transparent electrode layer 420 includes hydrogen, a mobility of electrons or holes can be improved and transmittance can be improved.

The first metal electrode layer 422 that is positioned on the first transparent electrode layer 420 and where the interconnector 142 is connected can include a metal as a base material. Any of various known metals can be used as a material of the first metal electrode layer 422. For example, the first metal electrode layer 422 can include particles of silver, aluminum, and copper, or silver, aluminum, or copper particles coated with silver (Ag) or tin (Sn). The first metal electrode layer 422 can include one kind or material particles, or two or more particles having different kinds or materials.

The first metal electrode layer 422 including the metal can interfere with an incidence of light, and the first metal electrode layer 422 can have a certain or predetermined pattern to minimize shading loss. Thus, light can be incident on a portion where the first metal electrode layer 422 is not formed.

The first metal electrode layer 422 can include a first finger line 42a and a first bus bar 42b. For example, a plurality of first finger lines 42a can extend in a first direction (a horizontal direction in the drawing) and can be positioned parallel to each other. A first bus bar 42b or a plurality of first bus bars 42b can be formed in a second direction (a longitudinal direction in the drawing) and can be electrically connected to the first finger line 42a. The interconnector 142 can be connected or attached to the first bus bar 42b. In the drawing, a peripheral line 42c entirely connecting ends of the plurality of first finger lines 42a can be formed at portions adjacent to both side edges. The peripheral line 42c can have the same or similar width as the first finger line 42a and can be formed of the same material as the finger line 42a. However, the peripheral line 42c can be not included.

The first finger lines 42a having a uniform width can be spaced from each other with a uniform pitch. Although the first finger lines 42a are parallel to a main edge of the solar cell 10 in the first direction, embodiments of the invention are not limited thereto. In this instance, a width of the interconnector 142 can be smaller than a pitch of the first finger line 42a, and can be larger than a width of the first finger line 42a. However, embodiments of the invention are not limited thereto and various modifications are possible.

As described above, the first bus bar 42b can be positioned so as to correspond to a portion where the interconnector 142 for connecting to adjacent solar cells 10 is positioned. The first bus bars 42b can be provided so as to one-to-one correspond to the interconnectors 142 on the same plane. Accordingly, in the embodiment, a number of the first bus bar 42b and a number of the interconnectors 142 can be the same at one surface of the solar cell 10.

Here, the first bus bar 42b can include a plurality of first pad portions 422b in the second direction corresponding to the respective interconnector 142. The first bus bar 42b can further include a first line portion 421b having a width smaller than that of the first pad portion 422b and longitudinally extending between the first pad portions 422b along a direction in which the interconnector 142 is connected.

The interconnector 142 can be stably attached to the electrode 42 and 44 by the plurality of first pad portions 422b having a relatively large width or area. In the drawing, it is exemplified that an outer pad positioned at an outer side of the first bus bar 42b has a larger area than other pads so that the interconnector 142 is stably attached to the first bus bar 42b. However, embodiments of the invention are not limited thereto. The first line portion 421b connects the plurality of first finger lines 42a and the first pad portion 422b to provide a path through which carriers can bypass when some of the first finger lines 42a are disconnected. A width of the first line portion 421b in the first direction can be smaller than a width of the first pad portion 422b and a width of the interconnector 142 in the first direction, and can be smaller than, larger than, or the same as a width of the first finger line 42a in the second direction. When the first line portion 421b has a relatively small width, an area of the first electrode 42 can be minimized and thus shading loss and a material cost can be reduced.

Similarly, in the embodiment, the second electrode 44 can include a second transparent electrode layer 440 and a second metal electrode layer 442. Since functions, materials, shapes, etc. of the second transparent electrode layer 440 and the second metal electrode layer 442 of the second electrode 44 are the same as those of the first transparent electrode layer 420 and the first metal electrode layer 442 of the first electrode 42, the description for the first electrode 42 can be applied to the second electrode 44 as it is, except that the second electrode 44 is positioned on the second conductive region 30.

The second metal electrode layer 442 can include a second finger line, a second bus bar, and/or a second peripheral line, and the second bus bar can include a plurality of second pad portions and/or a second line portion. The description of the first finger line 42a, the first bus bar 42b and the first peripheral line 42c of the first electrode 42 can be applied to the second finger line, the second bus bar, the second peripheral line of the second metal electrode layer 442 as they are. In this instance, the first bus bar 42b and the second bus bar can have the same number and the same pitch. The first finger line 42a and the second finger line can have the same width, pitch and/or number, and can have different widths, pitches, and/or numbers.

As described above, in the embodiment, the first and second metal electrode layers 422 and 442 of the solar cell 10 have a certain pattern, and the solar cell 10 has a bi-facial structure where light can be incident to the front surface and the back surface of the semiconductor substrate 12. Thus, an amount of light used in the solar cell 10 can be increased and it can contribute to an improvement of efficiency of the solar cell 1 0.

However, embodiments of the invention are not limited thereto. Therefore, the second metal electrode layer 442 can be entirely formed on the back surface of the semiconductor substrate 12. Also, the first and second conductive regions 20 and 30 and the first and second electrodes 42 and 44 are positioned together on one surface (for example, the back surface) of the semiconductor substrate 12. Further, at least one of the first and second conductive regions 20 and 30 is formed on or at both surfaces of the semiconductor substrate 12. That is, the above-described structure of the solar cell 10 is merely one example, but embodiments of the invention are not limited thereto.

Referring to FIG. 2 and FIG. 4, the moisture barrier layer 150 including silicon can be positioned between the solar cell 10 and the sealing member 130. In this instance, the moisture barrier layer 150 can be partially or entirely formed between the solar cell 10 and the sealing member 130. Since the moisture barrier layer 150 is positioned between the solar cell 10 and the sealing member 130, the moisture barrier layer 150 is entirely disposed within the sealing member 130 and is not exposed to the outside because it is surrounded by the sealing member 130. In instance where at least one of the first and second sealing members 131 and 132 is formed of a plurality of sealing layers, a part (for example, a side surface) of at least one layer of the plurality of sealing layers is exposed to the outside.

In this instance, as described above, the solar cell 10 includes a photoelectric conversion portion and the electrode 42 and 44 including the metal electrode layer 422 and 442 connected thereto. In the embodiment, the moisture barrier layer 150 can be positioned at least at a portion where the metal electrode layer 422 and 442 is not positioned. Particularly, the moisture barrier layer 150 can be positioned on the transparent electrode layer 420 and 440 at a portion where the metal electrode layer 422 and 442 is not formed. That is, the moisture barrier layer 150 can be positioned at least between the transparent electrode layer 420 and 440 and the sealing member 130. For example, the moisture barrier layer 150 can be in contact with the transparent electrode layer 420 and 440, the interconnector 142, and/or the sealing member 130. Thus, a structure can be simplified and effect of the moisture barrier layer 150 can be maximized.

The transparent electrode layer 420 and 440 can be hydrophilic. Thus, if moisture is present in the sealing member 130, undesired corrosion of the transparent electrode 420 and 440 can occur due to such moisture, and properties can be easily deteriorated. Alternatively, moisture penetrates between the conductive region 20 and 30 and the transparent electrode layer 420 and 440, and a passivation property at the interface can be largely lowered. Particularly, in the instance where the conductive region 20 and 30 includes amorphous silicon, a passivation property can be seriously deteriorated if moisture penetrates between the conductive region 20 and 30 and the transparent electrode layer 420 and 440.

In the embodiment, the moisture barrier layer 150 including silicon is provided at least between the transparent electrode layer 420 and 440 and the sealing member 130, and thus, degradation of the transparent electrode layer 420 and 440 and deterioration of the passivation property at the interface of the transparent electrode layer 420 and 440 can be prevented. For reference, in the conventional art, there are many solar cells in which electrodes 42 and 44 are mainly formed of metal electrode layers 422 and 442, and techniques for preventing corrosion of metal electrode layers have been mainly proposed. However, a technique for preventing corrosion or deterioration of the transparent electrode layer 420 and 440 when the transparent electrode layer 420 and 440 is provided together with the metal electrode layer 422 and 442 as in the embodiment has not been proposed. In a damp heat test in which temperature and humidity are varied, efficiency or output is lowered due to corrosion of the metal electrode layer 422 and 442 at the beginning, while the efficiency or the output is lowered due to corrosion of the transparent electrode layer 420 and 440 as the time goes or cycle is repeated. Although the reason for this is not specifically known, it is expected that the corrosion of the transparent electrode layers 420 and 440, the deterioration of properties of the interface between the transparent electrode layer 420 and 440 and the conductive region 20 and 30, or the deterioration of properties of the conductive regions 20 and 30 due to acidic material or moisture can induce a reduction in the efficiency or the output.

In this instance, the moisture barrier layer 150 can be formed of or include a resin including silicon or a compound particle including silicon to prevent water or moisture from reaching the solar cell 10 (particularly, the transparent electrode layers 420 and 440). In this instance, a concentration of an acetic acid in the moisture barrier layer 150 can be smaller than a concentration of an acetic acid in the sealing member 130. This is because no byproducts such as an acetic acid due to moisture or the like are generated in the moisture barrier layer 150.

As an example, the moisture barrier layer 150 can be formed of an organic material including a silane coupling agent. Here, the silane coupling agent can be a material including a first reactor chemically bonded to an organic material such as various synthetic resins or so on, and a second reactor chemically combined with an inorganic material such as glass, a metal, or so on. In this instance, the second reactor that chemically bonds with the inorganic material is coupled to the transparent electrode layer 420 and 440, and the first reactor that chemically bonds with the organic material can be coupled to the sealing member 130. The moisture barrier layer 150 including the silane coupling agent can be easily bonded to the surface of the transparent electrode layer 420 and 440 to prevent moisture from penetrating into the transparent electrode layer 42 and 440. As one example, various known reactors such as an amino group (-NH₂) can be used as the first reactor. By the second reactor, a Si-O-M bond (where M is a metal) can be formed. This is because an alkoxysilyl group (Si-OR) of the silane coupling agent is hydrolyzed by water or moisture to becomes a silanol group (Si-OH), and the Si-O-M can be formed through a condensation reaction of the silanol group and an inorganic surface. However, embodiments of the invention are not limited thereto, and any of various materials or combinations can be used for the first and second reactors.

In this instance, the moisture barrier layer 150 can include one or more of 3-aminopropyldimethylethoxysilane (APDMES), 3-aminopropyltriethoxysilane (APTES), allyltriethoxysilane (ATES), octadecyltrichlorosilane, or the like. The moisture barrier layer 150 formed of such a material can modify properties related to a moisture permeability to have excellent moisture-permeation prevention properties without undesirably changing other properties of the transparent electrode layer 420 and 440.

For example, a glass substrate constituting the first or second cover member 110 or 120 can be a soda-lime glass substrate. The soda-lime glass substrate has excellent properties and its cost is not high. However, when the soda-lime glass substrate is reacted with an acetic acid, sodium ions (Na +) are generated, the sodium ions are diffused, and an interface passivation property can be deteriorated. In this embodiment, the moisture barrier layer 150 serves as a sodium-ion barrier layer for preventing sodium-ion diffusion, and thus, it is possible to prevent the deterioration of the interface passivation property due to the sodium-ion diffusion described above. The moisture barrier layer 150 is not limited to the above-mentioned materials. In this embodiment, the moisture barrier layer 150 or the sodium-ion barrier layer can include a silicon nitride (SiNx) layer, a silicon oxide (SiOx) layer, or the like being able to prevent the sodium-ion diffusion.

As another example, as shown in an enlargement circle of FIG. 4, the moisture barrier layer 150 can be a silica layer including silica particles 150a. Here, the silica particles can be silica particles 150a having a silane coupling agent. As described above, when the moisture barrier layer 150 includes the silica particles 150a, a manufacturing process can be simplified and a cost can be reduced.

In this instance, an average particle diameter (an average particle size) of the silica particles 150a can be 20 nm to 1 um. When the average particle diameter of the silica particles 150a exceeds 1 um, the moisture barrier layer 150 can be unnecessarily thickened or a degree to which the silica particles 150a are dispersed at a portion adjacent to a surface can be reduced. When the average particle diameter of the silica particles 150a is less than 20 nm, the silica particles 140a can be difficult to be manufactured and effect of the moisture barrier layer 150 may not be effectively realized due to a small particle size. In the drawings, it is exemplified that the silica particles 150a have a shape of spherical particles, but embodiments of the invention are not limited thereto. The silica particles 150a can be used by mixing particles having different shapes or different particle diameters. Various other variations are possible.

The moisture barrier layer 150 can be entirely formed at least on one of surfaces (that is, a front surface, a back surface, and side surfaces) of the solar cell 10. That is, it is exemplified that the moisture barrier layer 150 is densely positioned at a surface portion of the solar cell 10 and is formed of one continuous layer without a break or breaking. Thus, effect of the moisture barrier layer 150 can be effectively realized, and the moisture barrier layer 150 can be formed without additional patterning, thereby simplifying a manufacturing process.

In the embodiment, the moisture barrier layer 150 can be positioned between the solar cell 10 and the sealing member 130 at a portion where the interconnector 142 is not positioned, and can be positioned between the interconnector 142 and the sealing member 130 at other portion where the interconnector 142 is positioned. That is, the moisture barrier layer 150 can be entirely disposed between the sealing member 130 and the solar cell 10 and the interconnector 142 while entirely covering or surrounding the solar cell 10 and the interconnector 142 together.

As described above, for example, the moisture barrier layer 150 can entirely cover the solar cell 10, thereby separating the solar cell 10 from the sealing member 130 as a whole to be apart from the sealing member 130. That is, the moisture barrier layer 150 includes a first portion 151, a second portion 152, and lateral portions 154. The first portion 151 can be positioned between the solar cell 10 and the first sealing member 131 on one surface (for example, a front surface) of the solar cell 10. The second portion 152 can be positioned between the solar cell 10 and the second sealing member 132 on the other surface (for example, a back surface) of the solar cell 10. The lateral portions 154 can be positioned between the solar cell 10 and the sealing members 131 on side surfaces of the solar cell 1 0. In this instance, the first portion 151, the second portion 152, and the lateral portions 154 can be continuously connected to each other without a disconnection. Thereby, there can be no portion where the solar cell 10 and the sealing member 130 are in contact with each other. Thus, deterioration of the transparent electrode layer 420 and 440 due to moisture penetration can be effectively prevented.

Particularly, when the moisture barrier layer 150 includes the lateral portion 154, the deterioration of the transparent electrode layer 420 and 440 or the deterioration of the passivation properties at the interface thereof can be effectively prevented. Each of the first transparent electrode layer 420 formed on the front surface of the solar cell 10 and the second transparent electrode layer 440 formed on the back surface of the solar cell 10 can be extended at side surfaces of the solar cell 10 in the embodiment. An isolation portion IS can be formed at the side surface to prevent unwanted electrical connection of the first and second transparent electrode layers 420 and 440. For example, the isolation portion IS can be formed of a trench shape. Interfaces between the semiconductor substrate 12, the transparent electrode layer 420 and 440, and the conductive region 20 and 30 can be exposed as it is through the isolation portion IS. Since the deterioration can be accelerated by a moisture penetration through such a portion, the moisture penetration through the side surfaces can be effectively prevented by the lateral portion 154. However, a side structure of the transparent electrode layer 420 and 440, the conductive region 20 and 30, and/or the semiconductor substrate 12 at the side surfaces of the semiconductor substrate 10 are not limited to the above description. Transparent electrode layers 420 and 440 can be formed only on the front and back surfaces and may not be formed on the side surfaces, and portions where the transparent electrode layers 420 and 440 are not formed can form a kind of an isolation portion. In this instance, the conductive regions 20 and 30 can be formed only on the front surface and the back surface corresponding to the transparent electrode layers 420 and 440, and may not be formed on the side surfaces. Alternatively, the first and second conductive regions 20 and 30 can extend at the side surfaces. In this instance, a trench-shaped isolation portion for separating the first and second conductive regions 20 and 30 from each other can be provided, or a portion between the first and second conductive regions 20 and 30 spaced apart from each other can be a kind of isolation portion. In these variations, the moisture barrier layer 150 can include or may not include the lateral portion 154. In addition, various structures can be applied.

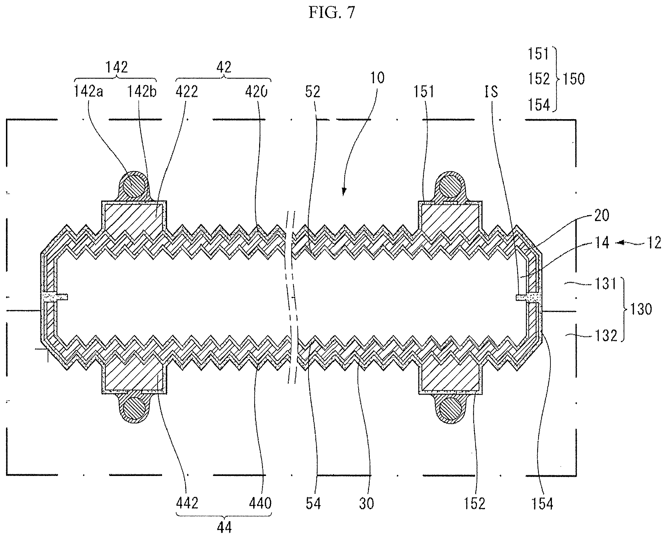

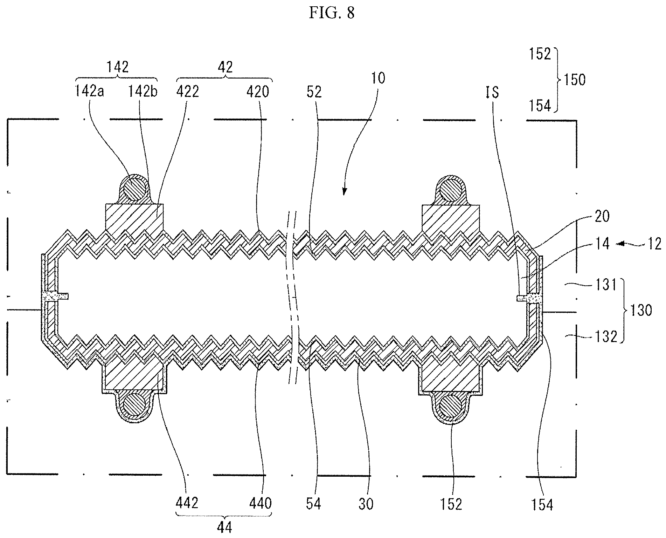

However, embodiments of the invention are not limited thereto, and the moisture barrier layer 150 can be formed at any of various positions while having any of various shapes. Various embodiments of a position, a shape, and the like of the moisture barrier layer 150 will be described in detail later with reference to FIGS. 7 and 8. Also, the moisture barrier layer 150 can be not formed at a part on the transparent electrode layer 420 and 440 and/or the interconnector 142.

In this instance, a thickness of the moisture barrier layer 150 can be smaller than a thickness of the sealing member 130 and can be less than 1 um. This is because the moisture barrier layer 150 does not need to have a large thickness because the moisture barrier layer 150 is just for modifying a surface of the transparent electrode layer 420 and 440 to prevent penetration of moisture. For example, the thickness of the moisture barrier layer 150 can be 1 nm or more (for example, 10 nm or more) so as to sufficiently perform the function of the moisture barrier layer 150.

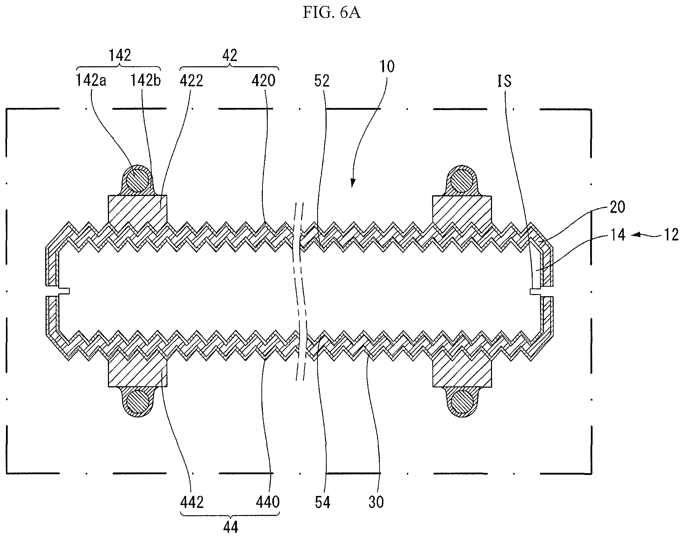

The moisture barrier layer 150 can be formed on the solar cell 10 and/or the interconnector 142 by any of various methods. For example, the moisture barrier layer 150 can be formed by a spraying method, a deposition method (for example, a plasma enhanced chemical vapor deposition (PECVD) method), a spin coating method, a dipping method, a sol-gel method, or the like. Then, the moisture barrier layer 150 can be easily formed on the solar cell 10 and/or the interconnector 142. The specific method of forming the moisture barrier layer 150 will be described later in more detail with reference to FIGS. 6A to 6C.

As described above, in FIG. 4, it is exemplified that the moisture barrier layer 150 is formed by surrounding the solar cell 10 to which the interconnector 142 is attached as a whole. When the interconnector 142 is attached to the solar cell 10 to form the solar cell string and then the moisture barrier layer 150 is formed, the moisture barrier layer 150 having such a structure can be formed. However, embodiments of the invention are not limited thereto. Other examples of this will be described in detail later with reference to FIG. 7.

As described above, according to the embodiment, the moisture barrier layer 150 including silicon is positioned on the surface of the solar cell 10 adjacent to the sealing member 130, and corrosion of the electrodes 42 and 44 can be effectively prevented. This effect can be further enhanced when the electrode 42 and 44 includes the transparent electrode layer 420 and 440 and the conductive region 20 and 30 includes amorphous silicon. As a result, output drop or power degradation that can occur in a high-temperature and high-humidity environment can be prevented or minimized, thereby improving long-term reliability of the solar cell panel 100.

As described above, when the long-term reliability of the solar cell panel 100 is improved, it is not necessary to precisely control properties of other elements considering the moisture penetration, thereby reducing a material cost. For example, the second cover member 120, the sealing member 130, and the like having very strict conditions were used in the conventional art in order to prevent moisture penetration. On the other hand, according to the embodiment, conditions of the second cover member 120, the sealing member 130, and the like can be mitigated, and thus, the material cost can be reduced. Accordingly, the second cover member 120 can be formed of a sheet or a film that does not include a metal or the like and includes a resin having a light-transmitting property. Accordingly, the solar cell 10 according to the embodiment can be applied to a solar cell panel 100 formed of a transparent panel that receives light on both sides. The first sealing member 131 and the second sealing member 132 can be formed of ethylene vinyl acetate rather than a polyolefin resin, and thus, the solar cell panel 100 can have excellent properties even at a low material cost.

Embodiments of the invention are not limited to the above structure of the solar cell 10, the above structure and number of the interconnectors 142 of FIGS. 1 to 5 and the above-described description. Accordingly, only one of the first and second transparent electrode layers 420 and 440 can be provided, or both the first and second transparent electrode layers 420 and 440 may not be provided. When the first or second transparent electrode layer 420 or 440 is not provided, an insulating layer can be positioned at a portion where the metal electrode layer 422 and 442 is not formed, and the moisture barrier layer 150 can be formed on the insulating layer. At least one of the conductive regions 20 and 30 can constitute a part of the semiconductor substrate 10, or at least one of the first and second passivation layers 52 and 54 can be not included. Various other variations are possible.

An example of a method for manufacturing the solar cell panel 100 will be described in detail with reference to FIGS. 6A to 6C.

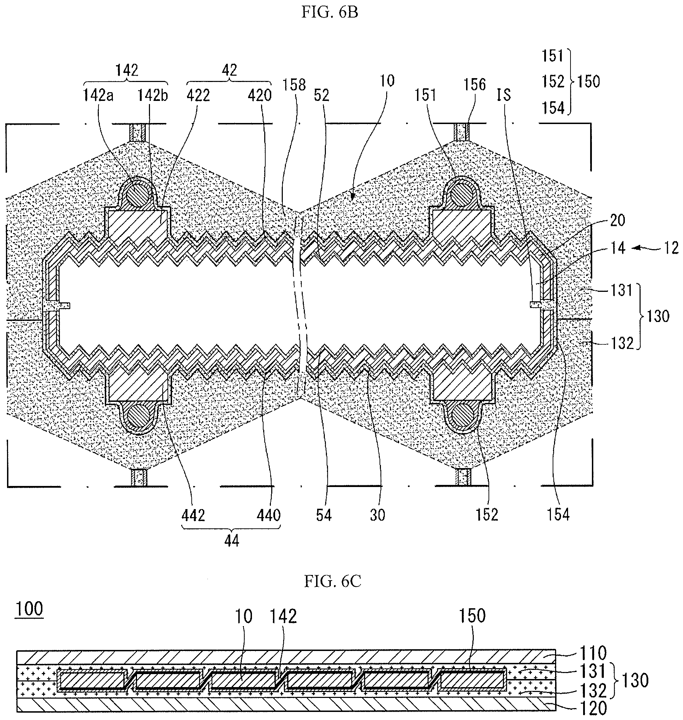

FIGS. 6A to 6C are cross-sectional views showing a method for manufacturing a solar cell panel according to an embodiment of the invention. For reference, FIGS. 6A and 6B show a portion corresponding to the portion shown in FIG. 4.

As shown in FIG. 6A, a solar cell 10 is manufactured. Any of various methods known as a method for manufacturing the solar cell 10 can be used.

As shown in FIG. 6B, a moisture barrier layer 150 is formed on a surface of the solar cell 10. In FIG. 6B, it is exemplified that the moisture barrier layer 150 is formed after an interconnector 142 is attached, but embodiments of the invention are not limited thereto.

Any of various methods can be applied as a method for forming the moisture barrier layer 150. For example, as described above, the moisture barrier layer 150 can be formed by a spraying method, a deposition method, a spin coating method, a dipping method, a sol-gel method, or the like.

Particularly, when the moisture barrier layer 150 includes an organic material 158 including a silane coupling agent, the organic material 158 including the silane coupling agent is sprayed through a spraying method. In the spraying method, the organic material 158 is sprayed by using a spraying nozzle 156 with pressure to scatter and is dried after spraying. Then, the moisture barrier layer 150 can be uniformly formed on the solar cell 10 using a small amount of the organic material 158.

That is, the moisture barrier layer 150 can be formed by applying the organic material 158 having the silane coupling agent to a wanted or desired position by a spraying method and then drying (for example, naturally drying, drying by a heat treatment or the like). In this instance, the organic material 158 having the silane coupling agent can be mixed with a solvent, a dispersant, and the like to be sprayed.

Then, a manufacturing process can be simple and be performed at a low process temperature, and the moisture barrier layer 150 can be applied over a large area and therefore mass productivity is excellent. In this instance, since wettability of the organic material 158 to the transparent electrode layer 420 and 440 is excellent, the moisture barrier layer 150 can be uniformly formed on the transparent electrode layer 420 and 440 as a whole.

As another example, when the moisture barrier layer 150 includes silica particles 150a (see FIG. 4), it can be formed by a sol-gel method. According to the sol-gel method, after a solution including a precursor is applied, the moisture barrier layer 150 having silica particles can be formed by hydrolysis, a dehydration condensation reaction, or the like. The silica particles having the silane coupling agent can be formed by any of various methods. For example, the moisture barrier layer 150 of the silica particles can be formed by a sol-gel method through applying a solution including one or more of tetramethyl orthosilicate, tetraethyl orthosilicate, tetrapropoxy silane, tetraisopropoxide, or the like as a precursor and drying the solution (for example, by a heat treatment at 200°C or less).

Next, as shown in FIG. 6C, the solar cell 10 having the moisture barrier layer 150 formed thereon, a sealing member 130 sealing the solar cell 10, a first cover member 110 positioned at one surface of the solar cell 10 on the sealing member 130, and a second cover member 120 positioned at the other surface of the solar cell 10 on the sealing member 130 are stacked and attached to each other. The moisture barrier layer 150 positioned on the surface of the solar cell 10 is positioned between the solar cell 10 and the sealing member 130 as it is.

In FIGS. 6B and 6C, it is exemplified that the moisture barrier layer 150 is formed as a whole on the solar cell 10 as shown in FIG. 4. However, embodiments of the invention are not limited thereto, and the moisture barrier layer 150 can be positioned as shown in FIG. 7 or FIG. 8 to be described later.

As described above, according to the embodiment, corrosion of the electrode 42 and 44 (in particular, the transparent electrode layer 420 and 440) due to moisture penetration can be prevented by a simple process, thereby providing the method of manufacturing the solar cell panel 100 being able to reduce or prevent output drop or power degradation by a simple process.

Hereinafter, a solar cell panel and a method for manufacturing the same according to other embodiments of the invention will be described in detail. The detailed description will be omitted for the same or extremely similar parts as the above description, and only the different parts will be described in detail. It is also within the scope of the invention to combine the above-described embodiments or variations thereof with the following embodiments or modifications thereof.

FIG. 7 is a schematic partial cross-sectional view of a solar cell panel according to another embodiment of the invention. For reference, a portion corresponding to FIG. 4 is shown in FIG. 7.

Referring to FIG. 7, in the embodiment, a moisture barrier layer 150 can be positioned between a solar cell 10 and an interconnector 142 at a portion where the interconnector 142 is positioned. More specifically, the moisture barrier layer 150 can include a portion positioned between a metal electrode layer 422 and 442 and the interconnector 142 at a portion where the interconnector 142 is positioned.

More specifically, the moisture barrier layer 150 can be positioned between a transparent electrode layer 420 and 440 and a sealing member 130 at portions where the metal electrode layer 422 and 442 does not exist. At a region where the metal electrode layer 422 and 442 is positioned, the moisture barrier layer 150 can be positioned between the metal electrode layer 422 and 442 and the interconnector 142 at a portion where the interconnector 142 is positioned, while can be positioned between the metal electrode layer 422 and 442 and the sealing member 130 at another portion where the interconnector 142 is not positioned. The moisture barrier layer 150 can be formed at the above-mentioned position by forming the moisture barrier layer 150 on the solar cell 10 and then attaching the interconnector 142 thereto.

An electrical connection between the metal electrode layer 422 and 442 and the interconnector 142 is not significantly disturbed even if the moisture barrier layer 150 is disposed on the metal electrode layer 422 and 442.

For example, like the moisture barrier layer 150 on the first metal electrode layer 422 at the right side of FIG. 7 or one the second metal electrode layer 442 at the left side of FIG. 7, the moisture barrier layer 150 is only partially formed on the metal electrode layer 422 and 442 and thus a portion where the interconnector 142 and the metal electrode layer 422 and 442 are in direct contact with each other can be provided. The portion where the moisture barrier layer 150 is not positioned on the metal electrode layer 422 and 442 can be intentionally formed through not forming the moisture barrier layer 150 on the metal electrode layer 422 and 442, or can be formed by a penetration of a solder material of the interconnector 142 through the moisture barrier layer 150 during a tabbing process.

As another example, like the moisture barrier layer 150 on the first metal electrode layer 422 at the left side of FIG. 7 or one the second metal electrode layer 442 at the right side of FIG. 7, the moisture barrier layer 150 can be entirely and continuously formed on the metal electrode layer 422 and 442. In this instance, the moisture barrier layer 150 can have a small thickness and may not interfere with an electrical connection between the interconnector 142 and the metal electrode layer 422 and 442.

Alternatively, a portion where the moisture barrier layer 150 is not entirely formed can be positioned to correspond to the interconnector 142 at a portion where the interconnector 142 is attached. That is, the moisture barrier layer 150 is not formed at the portion where the interconnector 142 is attached and thus the moisture barrier layer 150 is partially formed. Even if a part or a whole portion of the moisture barrier layer 150 is removed at a portion (for example, a bus bar) of the metal electrode layer 422 and 442 to which the interconnector 142 is attached, the moisture barrier layer 150 can remain on a portion (for example, a finger electrode) of the metal electrode layers 422 and 442 where the interconnector 142 is not positioned.

FIG. 8 is a schematic partial cross-sectional view of a solar cell panel according to yet another embodiment of the invention. For reference, a portion corresponding to FIG. 4 is shown in FIG. 8.

Referring to FIG. 8, in the embodiment, a moisture barrier layer 150 is partially formed on a surface of a solar cell 10.

For example, in FIG. 8, it is exemplified that the moisture barrier layer 150 is not formed on a front surface of the solar cell 10, but includes a second portion 152 disposed on a back surface of the solar cell 10 between the solar cell 10 and a second sealing member 132 and lateral portions 154 disposed on side surfaces of the solar cell 10 between the solar cell 10 and a sealing member 130. In the embodiment, since a second conductive region 30 acting as an emitter region is positioned, if properties at an interface between the second conductive region 30 and a second transparent electrode layer 442 adjacent thereto are lowered due to moisture, efficiency of the solar cell 10 can be more greatly affected. Accordingly, the moisture barrier layer 150 is positioned only on or at the back surface of the solar cell 10, not on the front surface thereof. As another example, only the lateral portion 154 can be formed while a first portion 151 (see FIG. 4) and the second portion 152 can be not provided.

However, embodiments of the invention are not limited thereto, and the moisture barrier layer 150 can be formed entirely or partially on at least one of the front surface, the back surface, and the side surfaces of the solar cell 10. It is exemplified that the moisture barrier layer 150 is positioned between the interconnector 142 and the sealing member 130 in FIG 8, like the embodiment in FIG. 4. However, as shown in FIG. 7, the moisture barrier layer 150 can be disposed between the interconnector 142 and the solar cell 10 (particularly, between the interconnector 142 and a metal electrode layer 420 and 442).

Hereinafter, the invention will be described in more detail by experimental examples of the invention. The following experimental examples are provided only for illustrating the invention, but embodiments of the invention are not limited thereto.

### Embodiment 1

A solar cell was prepared, and an interconnector was attached thereto. Then, a solution containing 3-aminopropyldimethylethoxysilane (APDMES) was sprayed onto the solar cell by a spraying process to form a moisture barrier layer. In this instance, a thickness of the moisture barrier layer was 0.1 um. Thereafter, a sealing member and first and second cover members were laminated to manufacture a solar cell panel.

### Comparative Example 1

A solar cell panel was manufactured in the same manner as in Embodiment 1, except that a moisture barrier layer was not formed.

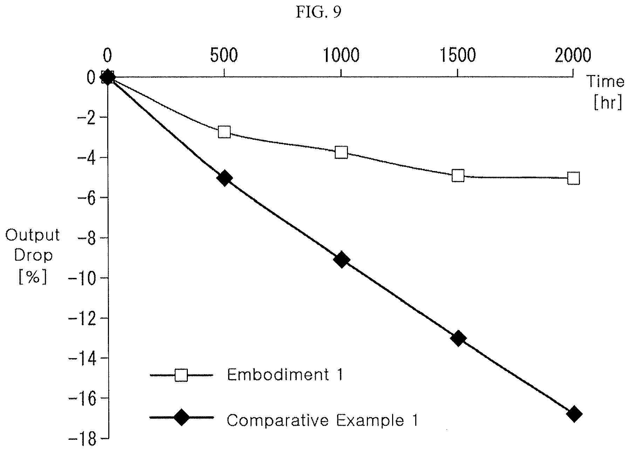

Damp heat tests were performed to the solar cell panels according to Embodiment 1 and Comparative Example 1. FIG. 9 shows output drops of solar cell panels according to Embodiment 1 and Comparative Example 1 according to a test time when the damp heat tests were conducted for 2000 hours. In this instance, output drop values shown in FIG. 9 are relative values of output drops in comparison with an initial output.

Referring to FIG. 9, the output drop of the solar cell panel according to Embodiment 1 is only about 5% after 2000 hours, while the output drop of the solar cell panel according to Comparative Example 1 is about 17 % after 2000 hours. Particularly, according to Embodiment 1, it can be seen that the output does not significantly decrease as time passes. This is expected that the moisture barrier layer prevents corrosion of a transparent electrode layer.

Thus, it can be seen that the moisture barrier layer according to Embodiment 1 can effectively prevent the output drop or the power degradation of the solar cell panel even after long-term use.

In the above-described embodiment, it is exemplified that the moisture barrier layer 150 is provided between the solar cell 10 and the sealing member 130. However, the embodiments are not limited thereto. Therefore, an additional moisture barrier layer can be disposed between the sealing member 130 and the first cover member 110 and/or between the sealing member 130 and the second cover member 120. The additional moisture barrier layer can be located only between the sealing member 130 and the first cover member 110, or only between the sealing member 130 and the second cover member 120, or between the sealing member 130 and the first and second cover member 110 and 130, respectively. A first additional moisture barrier layer positioned between the sealing member 130 and the first cover member 110 and a second additional moisture barrier layer positioned between the sealing member 130 and the second cover member 120 can be included. The first and second additional moisture barrier layers can be separate layers formed only on portions corresponding to the first and second cover members 110 and 120 and spaced apart from each other. As another example, the additional moisture barrier layer can include a first portion located between the sealing member 130 and the first cover member 110, a second portion located between the sealing member 130 and the second cover member 120, and third portions formed on side surfaces of the sealing member 130 to connect the first and second portions of the sealing member 130 to each other. Then, the additional moisture barrier layer can surround entire outer surfaces of the sealing member 130 as a single layer.

The additional moisture barrier layer can block water or sodium ions or the like flowing from the outside of the solar cell panel 100. For example, the moisture barrier layer 150 and the additional moisture barrier layer are both provided, and then, moisture or the like can be effectively prevented from flowing into the solar cell 10. As another example, the additional moisture barrier layer is provided while the moisture barrier layer 150 is not provided, or the moisture barrier layer 150 is provided while the additional moisture barrier layer is not provided.

The description about a material, a thickness, properties, a manufacturing method, and the like of the moisture barrier layer 150 can be applied to the additional moisture barrier layer as they are. Accordingly, it is also included in the embodiment of the invention that the content of the moisture barrier layer 150 is applied to the additional moisture barrier layer. Here, the additional moisture barrier layer can have the same material, thickness, properties, or manufacturing method as the moisture barrier layer 150 to simplify a process, or can have other materials, thickness, properties, or manufacturing method other than the moisture barrier layer 150 to enhance various properties.

The features, structures, effects and the like according to the above-described embodiments are included in at least one embodiment of the invention and are not necessarily limited to one embodiment. Further, the features, structures, effects and the like illustrated in the embodiments can be combined and modified by other persons skilled in the art to which the embodiments belong. Therefore, it is to be understood that embodiments of the invention are not limited to these embodiments.

## Claims

1. A solar cell panel comprising:
a solar cell;
a sealing member surrounding and sealing the solar cell;
a moisture barrier layer including silicon and positioned between the solar cell and the sealing member;
a first cover member positioned at a surface of the solar cell on the sealing member; and
a second cover member positioned at another surface of the solar cell on the sealing member.

2. The solar cell panel of claim 1, wherein the solar cell comprises a photoelectric conversion portion and an electrode including a metal electrode layer electrically connected to the photoelectric conversion portion, and
wherein the moisture barrier layer is positioned at at least a portion of the photoelectric conversion portion where the metal electrode layer is not positioned.

3. The solar cell panel of claim 2, wherein the photoelectric conversion portion comprises a semiconductor substrate, a passivation layer positioned on the semiconductor substrate, and a conductive region positioned on the passivation layer,
wherein the electrode further comprises a transparent electrode layer positioned on the conductive region, and the metal electrode layer is positioned on the transparent electrode layer and has a pattern, and
wherein the moisture barrier layer is positioned at least between the transparent electrode layer and the sealing member.

4. The solar cell panel of claim 3, wherein at least one of the following is fulfilled:
wherein the moisture barrier layer is in direct contact with at least the transparent electrode layer; and
wherein the conductive region comprises amorphous silicon.

5. The solar cell panel of claim 4, wherein the conductive region and the transparent electrode layer are in contact with each other.

6. The solar cell panel of one of claims 3 to 5, wherein the moisture barrier layer has a lateral portion positioned between the transparent electrode layer and the sealing member on a side surface of the solar cell.

7. The solar cell panel of one of preceding claims, wherein the moisture barrier layer is formed entirely on at least one surface of the solar cell.

8. The solar cell panel of claim 7, wherein the moisture barrier layer entirely covers the solar cell to separate the solar cell from the sealing member so that the solar cell is apart from the sealing member.

9. The solar cell panel of one of preceding claims, wherein the solar cell comprises a plurality of solar cells electrically connected by an interconnector,
wherein the moisture barrier layer is positioned between each solar cell and the sealing member at a portion where the interconnector is not positioned, and
wherein the moisture barrier layer is positioned between the interconnector and the sealing member or between each solar cell and the interconnector at a portion where the interconnector is positioned, or is not positioned at a portion where the interconnector is positioned.

10. The solar cell panel of one of preceding claims, wherein at least one of the following is fulfilled:
wherein the moisture barrier layer comprises a silane coupling agent; and
wherein the moisture barrier layer comprises silica particles.

11. The solar cell panel of claim 10, wherein at least one of the following is fulfilled:
wherein the moisture barrier layer comprises at least one of 3-aminopropyldimethylethoxysilane (APDMES), 3-aminopropyltriethoxysilane (APTES), allyltriethoxysilane (ATES), and octadecyltrichlorosilane; and
wherein an average particle diameter of the silica particles is approximately 20 nm to approximately 1 um.

12. The solar cell panel of one of preceding claims, wherein at least one of the following is fulfilled:
wherein the moisture barrier layer has a thickness of approximately 1um or less;
wherein a concentration of an acetic acid in the moisture barrier layer is lower than a concentration of an acetic acid in the sealing member; and
wherein the second cover member comprises a sheet or a film formed of a light-transmitting resin.

13. A method for manufacturing a solar cell panel, the method comprising:
forming a moisture barrier layer on a solar cell, the solar cell comprising a photoelectric conversion portion and an electrode; and
laminating and attaching the solar cell having the moisture barrier layer, a sealing member for sealing the solar cell, a first cover member positioned at a surface of the solar cell on the sealing member, and a second cover member positioned at another surface of the solar cell on the sealing member.

14. The method of claim 13, wherein the moisture barrier layer comprises an organic material including a silane coupling agent, and
wherein, in the forming of the moisture barrier layer, the moisture barrier layer is formed by spraying the organic material on the solar cell by a spraying method.

15. The method of claim 13 or 14, wherein the moisture barrier layer comprises silica particles, and
wherein, in the forming of the moisture barrier layer, a sol-gel method using a solution including a precursor of the silica particles is used.
